# EUROPÄISCHE PATENTSCHRIFT

(11) **EP 1 168 897 B1**
(45) Veröffentlichungstag und Bekanntmachung des Hinweises auf die Patenterteilung: **17.08.2005**
(21) Anmeldenummer: 01112929.3
(22) Anmeldetag: 06.06.2001
(51) Int. Cl.: H05K 1/11, H05K 3/00

(54) **Folienleiterplatte sowie deren Herstellungs- und Montageverfahren**
Foil printed circuit board and process for manufacturing and mounting the same
Panneau à circuit imprimé en feuille mince et son procédé de fabrication et de montage

(30) Priorität: 30.06.2000 DE 10031940
(43) Veröffentlichungstag der Anmeldung: 02.01.2002
(73) Patentinhaber: Coroplast Fritz Müller GmbH & Co. KG, 42279 Wuppertal (DE)
(72) Erfinder: Blaschke, Jörg, Dipl.-Phys.-Ing., 42369 Wuppertal (DE)
(74) Vertreter: Patentanwälte Dr. Solf & Zapf

(56) Entgegenhaltungen:
- EP-A- 0 848 583
- DE-A- 3 922 121
- DE-A- 19 720 167
- GB-A- 1 523 291
- "FLEXIBLE LAMINATE MATERIALS AFFECT CIRCUIT PERFORMANCE" ELECTRONIC PACKAGING AND PRODUCTION, CAHNERS PUBLISHING CO, NEWTON, MASSACHUSETTS, US, Bd. 34, Nr. 11, 1. November 1994 (1994-11-01), Seiten 34-36, XP000475077 ISSN: 0013-4945
- PATENT ABSTRACTS OF JAPAN vol. 015, no. 269 (E-1087), 9. Juli 1991 (1991-07-09) & JP 03 089587 A (NIPPON MEKTRON LTD), 15. April 1991 (1991-04-15)
- PATENT ABSTRACTS OF JAPAN vol. 017, no. 629 (E-1462), 19. November 1993 (1993-11-19) & JP 05 198912 A (TEIKOKU TSUSHIN KOGYO CO LTD), 6. August 1993 (1993-08-06)
- PATENT ABSTRACTS OF JAPAN vol. 2000, no. 09, 13. Oktober 2000 (2000-10-13) & JP 2000 164994 A (MATSUSHITA ELECTRIC IND CO LTD), 16. Juni 2000 (2000-06-16)
- PATENT ABSTRACTS OF JAPAN vol. 016, no. 478 (E-1274), 5. Oktober 1992 (1992-10-05) & JP 04 171786 A (SUMITOMO WIRING SYST LTD), 18. Juni 1992 (1992-06-18)
- PATENT ABSTRACTS OF JAPAN vol. 1997, no. 11, 28. November 1997 (1997-11-28) & JP 09 181401 A (SUMITOMO WIRING SYST LTD), 11. Juli 1997 (1997-07-11)

## Beschreibung

Die vorliegende Erfindung betrifft eine Folienleiterplatte, mit mindestens einer Trägerfolie, auf der elektrische Leiterzüge angeordnet sind, welche durch mindestens eine mit der Trägerfolie und den Leiterzügen verbundene Deckschicht abgedeckt sind, wodurch mindestens eine flexible gedruckte Schaltung aufgebaut ist, in der mindestens ein Leiterplattenbereich als Anschlußleitung ausgebildet ist, nach dem Oberbegriff des Anspruchs 1.

Des weiteren betrifft die vorliegende Erfindung ein Verfahren zur Herstellung einer derartigen Folienleiterplatte, das die Verfahrensschritte: Laminieren einer elektrischen Leiterschicht auf die Trägerfolie, Erzeugen eines Leiterbildes (insbesondere durch Drucken auf die Leiterschicht und Entwicklung der Leiterzüge durch Ätzen) und Aufbringen der Deckschicht auf den Verbund aus Trägerfolie und Leiterzügen umfaßt, nach dem Oberbegriff des Anspruchs 13.

Schließlich betrifft die vorliegende Erfindung auch ein Montageverfahren für eine Folienleiterplatte der genannten Art, das die Verfahrensschritte: Befestigen der Folienleiterplatte an einem Bauteil und Kontaktierung der Anschlußleitung an mindestens einer elektrischen Anschlußstelle umfaßt, nach dem Oberbegriff des Anspruchs 21.

Bei gedruckten Leiterplatten werden in allgemeiner Form zwei Gruppen unterschieden: eine Gruppe mit steifem und eine Gruppe mit flexiblem Träger, wobei die Leiterplatten der zweiten Gruppe auch als Folienleiterplatten bezeichnet werden können. Solche Folienleiterplatten, die bei der eingangs beschriebenen einfachen Herstellungsweise ein ausgezeichnetes Biegevermögen aufweisen, werden bevorzugt dort eingesetzt, wo sich elektrische Schaltungen problemlos der Geometrie des Einsatzortes anpassen müssen oder einer wiederholten Biegebeanspruchung unterworfen sind (beispielsweise in der Automobilindustrie oder in der Computertechnik). Sie weisen ein geringes Gewicht auf und können, da sie sehr flach sind, platzsparend in die verschiedensten Systeme integriert werden.

Bei Folienleiterplatten, die zur Herstellung sogenannter FPC's (Flexible Printed Circuits) verwendet werden, basiert das Material der Trägerfolie dabei zumeist auf Polyimid- oder Polyesterverbindungen, während die Leiterzüge aus elektrolytisch abgeschiedener oder gewalzter Kupferfolie bestehen. Für die Deckschicht kann entweder - wie für den Träger - ebenfalls eine Folie oder auch ein flexibler Lack zur Anwendung kommen. Trägerfolie, Leiterzüge und Deckschicht können mit Klebstoff und/oder unter Anwendung von Wärme und Druck miteinander verbunden werden.

Im Automobilbau finden FPC's Verwendung, die mindestens einen Leiterplattenbereich, in der Regel mehrere Leiterplattenbereiche, aufweisen, die jeweils als Anschlußleitung ausgebildet sind, an deren freien Ende sich ein Stecker befindet. Die Anschlußleitungen sind von den übrigen, insbesondere für eine Befestigung an einem Bauteil, wie einer Kraftfahrzeugkarosserie, vorgesehenen Leiterplattenbereichen separiert. Die Montage dieser bekannten FPC's ist im Vergleich mit der Montage von einfach oder gebündelt verlegten Kabeln bzw. Kabelsätzen vereinfacht: Die für die Befestigung vorgesehenen Leiterplattenbereiche werden an dem Bauteil befestigt, insbesondere mit diesem verklebt und dann die Anschlußleitungen elektrisch - insbesondere über Steckverbindungen - kontaktiert.

Sei es bei Verpackung, Versand und Transport, sei es beim Montagevorgang - wirken dabei jeweils die als Anschlußleitung ausgebildeten Leiterplattenbereiche, die einbaubedingt auch teilweise in größerer Länge ausgeführt sind, nachteiligerweise oft störend. Dies ist dadurch bedingt, daß sich einzelne Anschlußleitungen mit den daran befindlichen Steckern beispielsweise ineinander verhaken oder nach der Befestigung an der Kraftfahrzeugkarosserie von der Montagestelle ungeordnet und wirr herabhängen können.

Aus der DE-A-197 20 167 und der GB-A-1 523 291 sind eine Folienleiterplatte sowie ein Herstellungs- und ein Montageverfahren der eingangs genannten Art mit demgegenüber vereinfachter Montagemöglichkeit und Handhabbarkeit bekannt. So beschreibt die DE-A-197 20 167 eine Struktur zum Anschließen einer Mehrzahl voneinander entfernter elektrischer, Anschlußkontakte aufweisender Bauelemente an eine Zentraleinheit, die über Leiterbahnen mit Verbindungskontakten der Zentraleinheit verbunden ist. Dabei sind die Leiterbahnen auf einer flexiblen Leiterplatte derart ausgebildet, daß die flexible Leiterplatte vor dem Anschließen der Anschlußkontakte der voneinander entfernten Bauelemente eine kompakte Grundfläche aufweist, aus deren Randbereichen die Leiterbahnen nach Ausstanzen zumindest ihrer zu den Anschlußkontakten führenden Bereiche herausbiegbar sind, so daß beim Anschließen der Anschlußkontakte die flexible Leiterplatte eine sich nach außen hin verästelnde Gestalt annimmt, die eine gegenüber der kompakten Grundfläche vergrößerte Fläche überdeckt. Einen ähnlichen Stand der Technik beschreibt das genannte britische Dokument.

Der vorliegenden Erfindung liegt die Aufgabe zugrunde, eine Folienleiterplatte der eingangs genannten Art, sowie deren Herstellungs- und Montageverfahren derart zu verbessern, daß dadurch für die Folienleiterplatte eine noch weitergehend vereinfachte Montage und Handhabbarkeit, sowie auch ein weniger aufwändiger Transport möglich wird.

Diese Aufgabe wird mit einer Folienleiterplatte der eingangs genannten Art gelöst, die gemäß dem kennzeichnenden Teil des Anspruchs 1 ausgebildet ist.

Im Hinblick auf das Herstellungs- und das Montageverfahren wird diese Aufgabe dadurch gelöst, daß bei derartigen Verfahren der eingangs genannten Art die Merkmale des kennzeichnenden Teils des Anspruchs 13 bzw. des Anspruchs 21 vorgesehen sind.

Die Verbindung des als Anschlußleitung ausgebildeten Leiterplattenbereiches über die Schwächungslinie mit anderen Leiterplattenbereichen gestattet zunächst eine einfache und von freien Leitungsenden unbehinderte Handhabung der erfindungsgemäßen Folienleiterplatte. Diese kann nach ihrer Herstellung problemlos, insbesondere flächig und platzsparend, in Boxen versandfertig gepackt werden. Beim Anwender kann dann zunächst die Folienleiterplatte an die Montagestelle, beispielsweise in einer Autokarosserie, gebracht und dort befestigt werden. Anschließend wird/werden entsprechend dem erfindungsgemäßen Montageverfahren der als Anschlußleitung ausgebildete Leiterplattenbereich oder auch mehrere solche Bereiche von Hand an der/den Schwächungslinie(n) von der Folienleiterplatte ab- bzw. daraus herausgetrennt und zu verschiedenen elektrischen Anschlußstellen gefaltet bzw. verlegt und dort kontaktiert, insbesondere gesteckt.

Bei der Schwächungslinie, die die Funktion einer Sollbruchlinie erfüllt, kann es sich dabei vorzugsweise um eine Perforationslinie handeln, die vorteilhafterweise technologisch einfach, beispielsweise durch Stanzen, in die erfindungsgemäße Folienleiterplatte einbringbar ist. Alternativ ist es z.B. auch möglich, die Schwächungslinie als geritzte Linie auszuführen.

Ein anderer Leiterplattenbereich, mit dem der als Anschlußleitung ausgebildete Leiterplattenbereich über die Schwächungslinie verbunden ist, kann beispielsweise ein weiterer als Anschlußleitung ausgebildeter Leiterplattenbereich oder auch ein zur Befestigung an einem Bauteil, wie einem Kraftfahrzeug-Karosserieteil, bestimmter Leiterplattenbereich sein.

Dabei ist in jedem Fall erfindungsgemäß vorgesehen, daß auf der Folienleiterplatte zwei oder mehr Schaltkreise bzw. flexible gedruckte Schaltungen (FPC) gebildet sind, die über mindestens eine in der Trägerfolie und in der Deckschicht angeordnete Schwächungslinie miteinander verbunden sind. Eine auf diese Weise gebildete mattenartige (oder auch Bogen-)Struktur der Leiterplatte wird als Nutzen bezeichnet, wobei ein solcher Nutzen, dann mehrere gleichartige oder ungleichartige Schaltkreise zur Anbringung an einem oder mehreren Bauteil(en), z.B. einer Kraftfahrzeug-Karosserie, umfassen kann. Durch diese Zusammenfassung mehrerer FPC in Nutzen, die vorteilhafterweise durch Zuschnitt als aufeinanderfolgende Bögen einer Folienleiterplatten-Rolle gefertigt und zum Versand gebracht werden können, wird die Herstellung und Handhabung der erfindungsgemäßen Folienleiterplatte noch einfacher, und die Folienleiterplatte wird noch montagefreundlicher.

Weitere vorteilhafte Ausführungen der Erfindung sind in den Unteransprüchen und der nachfolgenden speziellen Beschreibung enthalten.

Anhand eines in der beiliegenden Zeichnung dargestellten Ausführungsbeispiels wird die Erfindung näher erläutert.

Dabei zeigen:
- Fig. 1: eine erste Variante des Aufbaus einer flexiblen gedruckten Schaltung (FPC) auf einer erfindungs gemäßen Folienleiterplatte, im Querschnitt, in einem Bereich entlang Linie I-I in Fig. 4,
- Fig. 2: die erste Variante des Aufbaus einer flexiblen gedruckten Schaltung (FPC) auf einer erfindungsgemäßen Folienleiterplatte, im Querschnitt, in einem Bereich entlang Linie II-II in Fig. 4,
- Fig. 3: in einer Fig. 1 entsprechenden Darstellung eine zweite Variante des Aufbaus einer flexiblen gedruckten Schaltung (FPC) auf einer erfindungsgemäßen Folienleiterplatte, im Querschnitt, in einem Bereich entlang Linie I-I in Fig. 4,
- Fig. 4: eine Draufsicht auf eine erfindungsgemäße Folienleiterplatte,
- Fig. 5: eine Draufsicht auf eine erfindungsgemäße Folienleiterplatte, in einer späteren Fertigungsstufe als in Fig. 4,
- Fig. 6: die exemplarische Veranschaulichung eines Montageschrittes einer erfindungsgemäßen Folienleiterplatte,
- Fig. 7: die exemplarische Veranschaulichung eines weiteren Montageschrittes einer erfindungsgemäßen Folienleiterplatte.

In den verschiedenen Figuren der Zeichnung sind gleiche Teile stets mit denselben Bezugszeichen versehen und werden daher in der Regel auch jeweils nur einmal beschrieben.

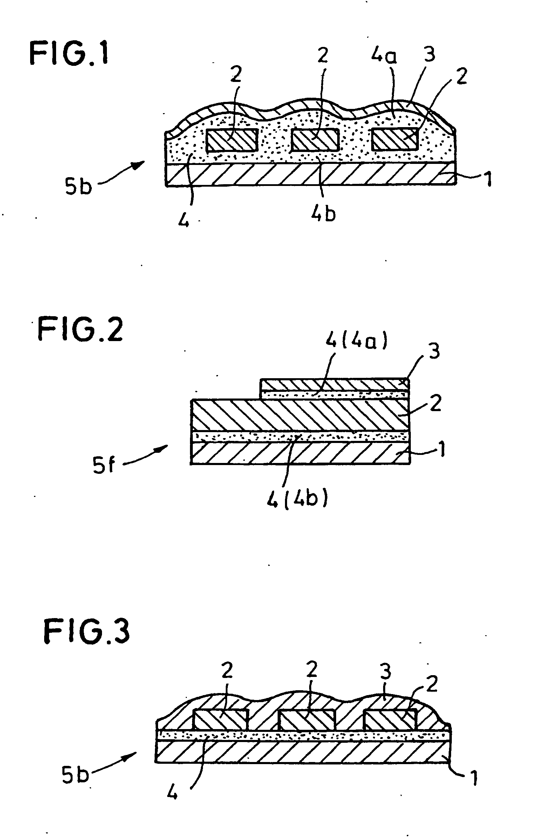

Wie aus Fig. 1 bis 3 hervorgeht, weist eine erfindungsgemäße Folienleiterplatte eine Trägerfolie 1 auf, auf der elektrische Leiterzüge 2 angeordnet sind, welche durch eine Deckschicht 3 abgedeckt sind. Dadurch ist mindestens eine flexible gedruckte Schaltung (FPC) gebildet. (In der dargestellten Ausführung der Erfindung sind auf der Folienleiterplatte jedoch mehrere FPC's A, B, C, D, E, F gebildet, worauf nachfolgend noch im Detail eingegangen wird.)

Gemäß einer ersten Variante (Fig. 1 und 2) des Aufbaus der FPC kann die Deckschicht dabei aus einer Deckfolie, gemäß einer zweiten Variante (Fig. 3) auch aus einem Decklack bestehen.

Die Trägerfolie 1, die Leiterzüge 2 und die Deckschicht 3 können vorzugsweise - wie dargestellt - über Klebeverbindungen 4 verbunden sein.

Ein solcher FPC-Aufbau ist an sich bekannt. Nachfolgend werden zu den einzelnen Folien- und Klebstoffschichten 1, 2, 3, 4 exemplarisch Dickenangaben aufgeführt, die aber jeweils im Bereich von 5 bis 10 µm Mikrometer nach oben oder unten von den angegebenen Werten abweichen können:

| | |
|---|---|
| Trägerfolie 1 | 50 µm |
| obere Kleberschicht 4a (Fig. 1, 2) | 25 µm |
| Leiterzüge 2 (Kupferfolie) | 70 µm |
| untere Kleberschicht 4b (Fig. 1, 2) | 35 µm |
| Deckfolie (Deckschicht 3 - Fig. 1) | 50 µm |
| Decklack (Deckschicht 3 - Fig. 3) | 30 µm |

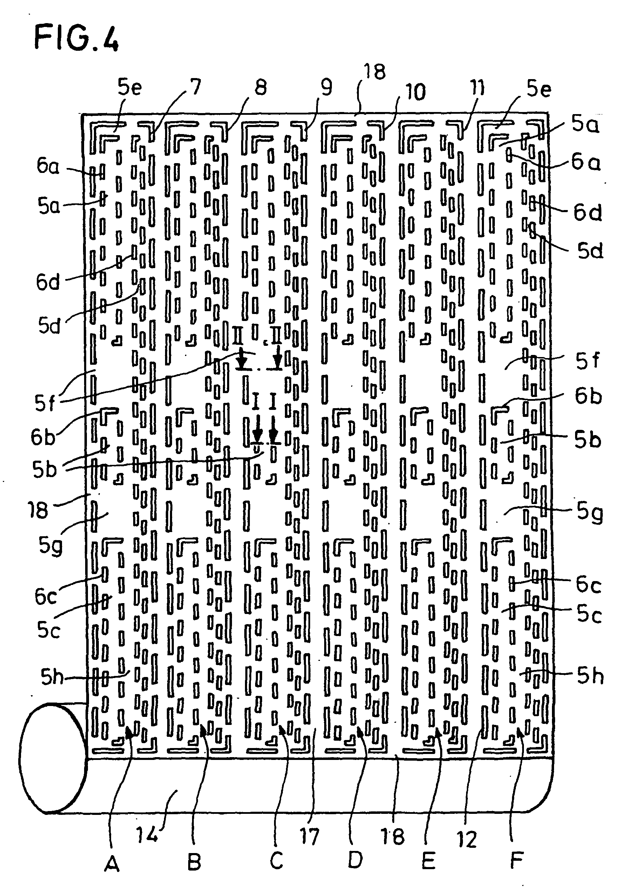

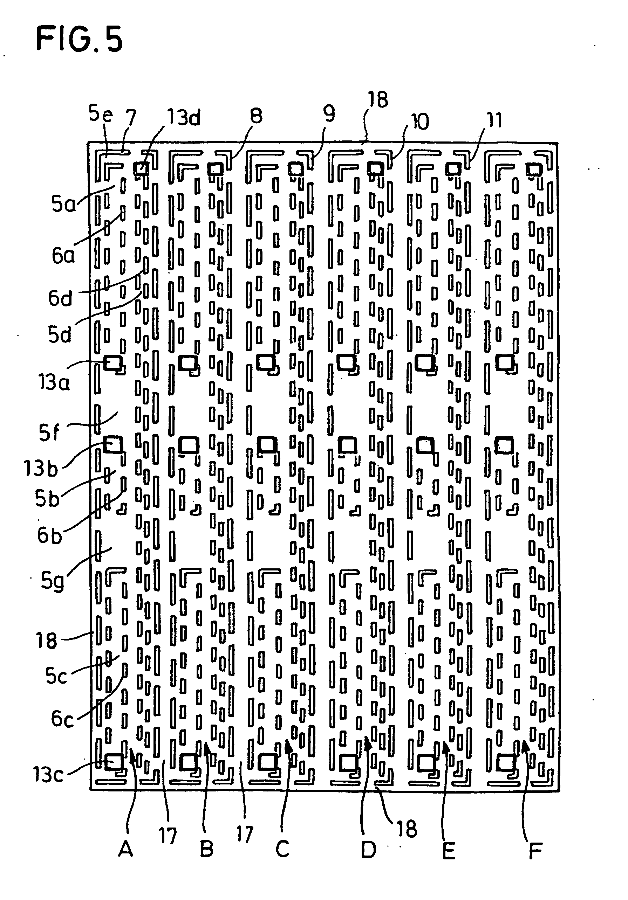

Wie des weiteren Fig. 4 und 5 veranschaulichen, ist bei der FPC auf der erfindungsgemäßen Folienleiterplatte mindestens ein Leiterplattenbereich, entsprechend der figürlichen Darstellung jedoch vorzugsweise mehrere Leiterplattenbereiche 5a, 5b, 5c, 5d, jeweils als elektrische Anschlußleitung ausgebildet.

Diese als elektrische Anschlußleitungen ausgebildeten Leiterplattenbereiche 5a, 5b, 5c, 5d sind jeweils über in der Trägerfolie 1 und in der Deckschicht 3 angeordnete Schwächungslinien 6a, 6b, 6c, 6d mit anderen Leiterplattenbereichen 5e, 5f, 5g, 5h verbunden. Im Ausführungsbeispiel sind die Schwächungslinien 6a, 6b, 6c, 6d dabei derart ausgeführt, daß sie die als Anschlußleitungen ausgebildeten Leiterplattenbereiche 5a, 5b, 5c, 5d vollständig umfassen.

Bei den Schwächungslinien 6a, 6b, 6c, 6d kann es sich dabei mit Vorteil - wie dargestellt - um Perforationslinien handeln, die einfach durch Stanzen in die erfindungsgemäße Folienleiterplatte eingebracht werden können. Alternativ wäre es aber beispielsweise auch mit Vorteil möglich, die Schwächungslinien 6a, 6b, 6c, 6d durch Ritzen des Verbundes aus Trägerfolie 1 und Deckschicht 3 (Ritzen von Trägerfolie 1 und/oder Deckschicht 3) zu erzeugen.

Im dargestellten Beispiel handelt es sich bei den Leiterplattenbereichen 5e, 5f, 5g, 5h, mit dem jeweils ein als Anschlußleitung ausgebildeter Leiterplattenbereich 5a, 5b, 5c, 5d über die Schwächungslinien 6a, 6b, 6c, 6d verbunden ist, um Leiterplattenbereiche, die zur Befestigung an einem Bauteil, wie einem Kraftfahrzeug-Karosserieteil, bestimmt sind. Es könnten aber auch zwei als Anschlußleitung ausgebildete Bereiche 5a, 5b, 5c, 5d - über Schwächungslinien 6a, 6b, 6c, 6d verbunden - nebeneinander liegen.

Wie außerdem aus Fig. 4 und 5 hervorgeht, kann es vorteilhafterweise vorgesehen sein, daß durch die Leiterzüge 2 zwei oder mehr Schaltkreise bzw. FPC gebildet sind, die über mindestens eine in der Trägerfolie 1 und/oder in der Deckschicht 3 angeordnete Schwächungslinie miteinander verbunden sind. In der in Fig. 4 und 5 dargestellten Ausführung sind sechs gleichartige FPC A, B, C, D, E, F gebildet, die jeweils durch Schwächungslinien umfaßt sind, die mit den Bezugszeichen 7 bis 12 bezeichnet sind. Auch bei diesen Schwächungslinien 7, 8, 9, 10, 11, 12 kann es sich beispielsweise - wie dargestellt - um Perforationslinien oder auch um geritzte Linien handeln.

Wie bereits erwähnt, wird eine auf diese Weise gebildete mattenartige (oder auch Bogen-)Struktur der erfindungsgemäßen Folienleiterplatte als Nutzen bezeichnet, wobei ein solcher Nutzen, auch mehrere ungleichartige Schaltkreise zur Anbringung an einem oder mehreren Bauteil(en), z.B. einer Kraftfahrzeug-Karosserie, umfassen könnte.

Insbesondere innerhalb einer als Perforationslinie ausgebildeten Schwächungslinie 7, 8, 9, 10, 11, 12, über die mindestens zwei Schaltkreise A, B, C, D, E, F bzw. flexible gedruckte Schaltungen (FPC) miteinander verbunden sind, können alternierend vorzugsweise kurze stegartige Verbindungsabschnitte und um ein Mehrfaches längere Schlitzabschnitte angeordnet sein, so daß sich die einzelnen FPC A, B, C, D, E, F in einfacher Weise manuell aus dem Nutzen heraustrennen lassen.

Die Herstellung einer erfindungsgemäßen Folienleiterplatte umfaßt zunächst folgende Verfahrensschritte: Laminieren einer elektrischen Leiterschicht auf die Trägerfolie 1, Drucken eines Leiterbildes auf die Leiterschicht, Entwicklung der Leiterzüge 2 des Leiterbildes durch Ätzen der Leiterschicht und Aufbringen der Deckschicht 3 (durch Folienlaminierung oder Lackauftragung) auf den Verbund aus Trägerfolie 1 und Leiterzügen 2. Gemäß dem Verfahren der Erfindung werden dann - nach dem Aufbringen der Deckschicht 3 - in den Verbund von Trägerfolie 1 und Deckschicht 3, insbesondere durch Perforieren oder Ritzen, zwischen den jeweils als Anschlußleitung ausgebildeten Leiterplattenbereich 5a, 5b, 5c, 5d und einen oder mehrere andere Leiterplattenbereiche jeweils Schwächungslinien 6a, 6b, 6c, 6d eingebracht.

Gleichzeitig und in gleicher Weise können dabei, für den Fall, daß durch das Drucken des Leiterbildes und die Entwicklung der Leiterzüge 2 zwei oder mehr Schaltkreise bzw. flexible gedruckte Schaltungen A, B, C, D, E, F und damit ein Nutzen gebildet werden sollen, auch zwischen diese Schaltungen die entsprechenden Schwächungslinien 7, 8, 9, 10, 11, 12 eingebracht werden.

Der jeweilige als Anschlußleitung ausgebildete Leiterplattenbereich 5a, 5b, 5c, 5d kann nach dem Aufbringen der Deckschicht 3 und insbesondere auch nach dem Einbringen der Schwächungslinien 6a, 6b, 6c, 6d, 7, 8, 9, 10, 11, 12, in einem Endabschnitt, der etwa der Größe eines Steckerteiles entspricht, aus der Folienleiterplatte herausgetrennt und, insbesondere mittels eines Crimpautomaten, mit einem Steckerteil 13a, 13b, 13c, 13d konfektioniert werden. Fig. 5 zeigt eine erfindungsgemäße Folienleiterplatte nach diesem Fertigungsschritt, bei der jeweils an einem freien Ende der als Anschlußleitung ausgebildeten Leiterplattenbereiche 5a, 5b, 5c, 5d ein Steckerteil 13a, 13b, 13c, 13d befestigt ist.

Der FPC-Fertigungsablauf kann dabei vorteilhafterweise von "Rolle zu Rolle" erfolgen, d.h., daß die Trägerfolie 1 einschließlich der Leiterschicht als Rollenbahn 14 (vgl. Fig. 4) eingesetzt wird, die jeweils vor dem Drucken des Leiterbildes, vor der Entwicklung der Leiterzüge 2, vor dem Aufbringen der Deckschicht 3 und vor dem Konfektionieren aufgerollt und jeweils nach dem Drucken des Leiterbildes, nach der Entwicklung der Leiterzüge 2 und nach dem Einbringen der Schwächungslinien 6a, 6b, 6c, 6d, 7, 8, 9, 10, 11, 12 eingerollt sowie nach dem Konfektionieren in Bögen (Nutzen) geschnitten wird. Vor dem Zuschnitt kann dabei mit Vorteil noch eine Qualitätsprüfung erfolgen.

Ein solcher, mit Steckern 13a, 13, 13c, 13c, 13d bestückter und zugeschnittener Nutzen, wie ihn Fig. 5 zeigt, kann beispielsweise die Abmaße 600 mm x 1500 mm aufweisen und ist versandfertig, wobei er zum Versand flächig und platzsparend in Boxen verpackt werden kann.

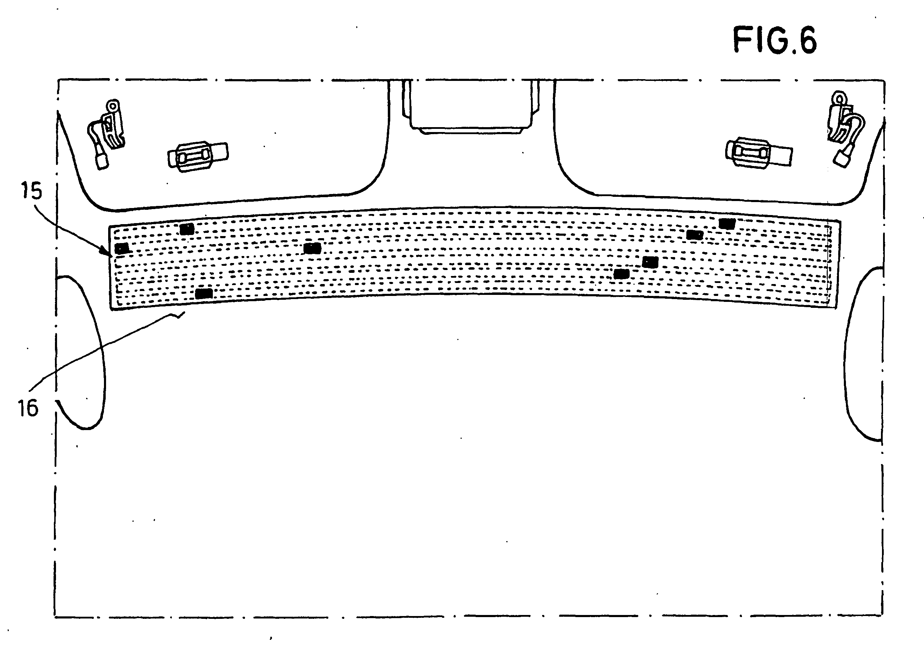

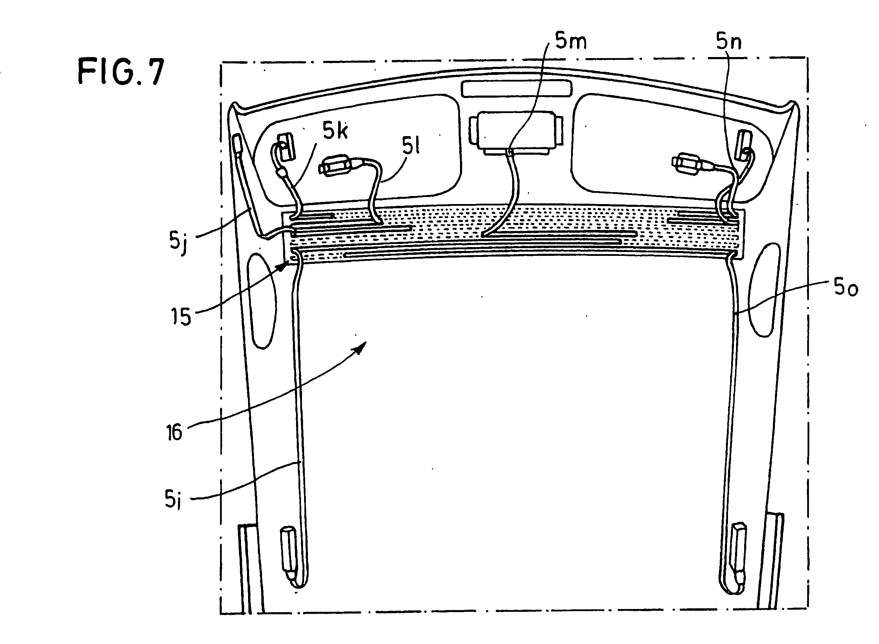

Das erfindungsgemäße Montageverfahren für eine erfindungsgemäße Folienleiterplatte wird durch Fig. 6 und 7 veranschaulicht und umfaßt die Verfahrensschritte: Befestigen der Folienleiterplatte (nur in Fig. 6 und 7 mit dem Bezugszeichen 15 bezeichnet) an einem Bauteil 16 - bei der dargestellten, als Variante zum Beispiel gemäß Fig. 4 und 5 aufgefaßten Ausführung ein Formhimmel eines Automobils- und Kontaktierung von jeweils als Anschlußleitung ausgebildeten Leiterplattenbereichen (in Fig. 7 mit den Bezugszeichen 5i, 5j, 5k, 5l, 5m, 5n und 5o bezeichnet) an jeweils einer elektrischen Anschlußstelle.

Wie Fig. 6 zeigt, bleibt dabei jeweils der als Anschlußleitung ausgebildete Leiterplattenbereich 5i, 5j, 5k, 5l, 5m, 5n, 5o bis nach dem Befestigen der Folienleiterplatte 15 an dem Bauteil 16 über die in den Verbund von Trägerfolie 1 und Deckschicht 3 angeordneten Schwächungslinien (In Fig. 6 und 7 nicht näher bezeichnet) mit einem oder mehreren anderen Leiterplattenbereichen verbunden. Erst anschließend (Fig. 7) werden diese Leiterplattenbereiche 5i, 5j, 5k, 5l, 5m, 5n, 5o an den Schwächungslinien von der Folienleiterplatte ab- bzw. daraus herausgetrennt, zu der jeweiligen elektrischen Anschlußstelle geführt und dort kontaktiert.

Vor dem Befestigen der Folienleiterplatte 15 an dem Bauteil 16 können, falls zwei oder mehr FPC's vorliegen, welche über mindestens eine im Verbund von Trägerfolie 1 und Deckschicht 3 angeordnete Schwächungslinie untereinander in einem Bogen (Nutzen) verbunden sind, diese an der jeweiligen Schwächungslinie manuell voneinander getrennt werden.

Die erfindungsgemäße Folienleiterplatte 15 kann mit dem Bauteil 16 zum Befestigen insbesondere verklebt werden. Dazu kann vorzugsweise ein doppelseitiges Hybridklebeband eingesetzt werden, wobei dieses zuerst mit einer Klebeseite auf das Bauteil 16 geklebt wird und wobei danach die Verklebung der Folienleiterplatte 15 mit der anderen Klebeseite erfolgt. Hinsichtlich weiterer Einzelheiten eines solchen besonders geeigneten Klebebandes wird in vollem Umfang auf die deutsche Gebrauchsmusteranmeldung 299 22 805.3 verwiesen.

Die Erfindung beschränkt sich nicht auf das beschriebene Ausführungsbeispiel, sondern umfaßt auch alle im Rahmen der Erfindung, wie beanspruchs, gleichwirkenden Ausführungen. So fällt es beispielsweise auch in den Rahmen der Erfindung, wenn, wie in der deutschen Gebrauchsmusteranmeldung 299 16 367.9 vorgeschlagen wurde, in einem Endabschnitt des als Anschlußleitung ausgebildeten Leiterplattenbereiches nach dem Aufbringen der Deckschicht aus der Schaltung selbst, insbesondere durch Faltung, ein Steckerteil gebildet wird.

Die erfindungsgemäße Folienleiterplatte 15 kann mit dem Bauteil 16 zum Befestigen alternativ zu der beschriebenen Verklebung auch ultraschallverschweißt oder über ein Klettband verbunden werden.

In einem Nutzen können - wie dargestellt - einzelne FPC A, B, C, D, E, F, über die Schwächungslinien 7, 8, 9, 10, 11, 12 derart miteinander verbunden werden, daß nach ihrem Heraustrennen noch Zwischenstege 17 oder am Nutzenrand Randstege 18 verbleiben. Dies gestattet eine Arbeit mit größeren zulässigen Fertigungstoleranzen. Andererseits könnte gegebenenfalls - im Sinne einer hohen Materialökonomie - bei geringeren zulässigen Toleranzen auch jeweils nur eine Schwächungslinie zwei nebeneinander angeordnete FPC's unmittelbar voneinander abgrenzen und auf einen Randsteg 18 im Nutzen könnte verzichtet werden.

Hinsichtlich der Lage der Schwächungslinien 6a, 6b, 6c, 6d, 7, 8, 9, 10, 11, 12 ist noch zu bemerken, daß diese die Leiterzüge 2 des FPC - beispielsweise drei in einem Bereich 5b, der als Anschlußleitung ausgebildet ist (vgl. Fig. 1 und 4) oder einen einzigen, flächigen in einem anderen Bereich 5f (vgl. Fig. 2 und 4) nicht verletzen dürfen. Insofern ist es auch zweckmäßig, wenn sich im Bereich der Zwischenstege 17 und Randstege 18 zwischen der Trägerfolie 1 und der Deckschicht 3 keine Leiterschicht befindet.

Des weiteren sind durch die Erfindung, soweit diese flexibel sind, Multilagenplatten (sog. Built-up-Platten) mit mehreren übereinanderliegenden, durch Zwischenschichten getrennten Leiterzügen 2 umfaßt, wie sie in den letzten Jahren weite Verbreitung gefunden haben.

### Bezugszeichen

- 1: Trägerfolie
- 2: Leiterzug
- 3: Deckschicht
- 4: Klebeverbindung (zwischen 1 und 2 bzw. 2 und 3)
- 4a: Klebeverbindung zwischen 2 und 3
- 4b: Klebeverbindung zwischen 1 und 2
- 5a-5d: Anschlußleitungs-Leiterplattenbereiche
- 5e-5h: Leiterplattenbereiche
- 5i-5o: Anschlußleitungs-Leiterplattenbereiche
- 6a-6d: Schwächungslinien bei 5a-5d
- 7-12: Schwächungslinien bei A-F
- 13a-13d: Stecker für 5a-5d
- 14: Rollenbahn
- 15: Folienleiterplatte (nur Fig. 6 und 7)
- 16: Bauteil
- 17: Zwischensteg
- 18: Randsteg

- A-F: Einzel-FPC im Nutzen

## Patentansprüche

1. Folienleiterplatte(15), mit mindestens einer Trägerfolie (1), auf der elektrische Leiterzüge (2) angeordnet sind, welche durch mindestens eine mit der Trägerfolie (1) und den Leiterzügen (2) verbundene Deckschicht (3) abgedeckt sind, wodurch mindestens eine flexible gedruckte Schaltung (A-F) aufgebaut ist, in der mindestens ein Leiterplattenbereich (5a-5d, 5i-5o) als Anschlußleitung ausgebildet ist, wobei der als Anschlußleitung ausgebildete Leiterplattenbereich (5a-5d, 5i-5o) über mindestens eine in dem Verbund von Trägerfolie (1) und Deckschicht (3) angeordnete Schwächungslinie (6a-6d) mit einem oder mehreren anderen Leiterplattenbereichen (5e-5h, 17, 18) verbunden ist,
**dadurch gekennzeichnet, daß** die Trägerfolie (1) einschließlich der Leiterzüge (2) und der Deckschicht (3) als Rollenbahn (14) ausgeführt ist, in der mehrere, in Bögen (Nutzen) angeordnete, über mindestens eine Schwächungslinie (7-12) verbundene, manuell voneinander trennbare, flexible gedruckte Schaltungen (A-F) angeordnet sind.

2. Folienleiterplatte nach Anspruch 1,
**dadurch gekennzeichnet, daß** mehrere Leiterplattenbereiche (5a-5d, 5i-5o) als Anschlußleitungen ausgebildet sind.

3. Folienleiterplatte nach Anspruch 1 oder 2,
**dadurch gekennzeichnet, daß** ein Leiterplattenbereich, mit dem jeweils der als Anschlußleitung ausgebildete Leiterplattenbereich (5a-5d, 5i-5o) über die Schwächungslinie (6a-6d) verbunden ist, ein weiterer als Anschlußleitung ausgebildeter Leiterplattenbereich (5a - 5d, 5i-5o) ist.

4. Folienleiterplatte nach einem der Ansprüche 1 bis 3,
**dadurch gekennzeichnet, daß** ein Leiterplattenbereich (5e-5h), mit dem jeweils der als Anschlußleitung ausgebildete Leiterplattenbereich (5a-5d, 5i-5o) über die Schwächungslinie (6a-6d) verbunden ist, ein zur Befestigung an einem Bauteil, wie einem Kraftfahrzeug-Karosserieteil, bestimmter Leiterplattenbereich ist.

5. Folienleiterplatte nach einem der Ansprüche 1 bis 4,
**dadurch gekennzeichnet, daß** die Trägerfolie (1), die Leiterzüge (2) und die Deckschicht (3) über Klebeverbindungen (4, 4a, 4b) verbunden sind.

6. Folienleiterplatte nach einem der Ansprüche 1 bis 5,
**dadurch gekennzeichnet, daß** die Deckschicht (3) aus einer Deckfolie besteht.

7. Folienleiterplatte nach einem der Ansprüche 1 bis 5,
**dadurch gekennzeichnet, daß** die Deckschicht (3) aus einem flexiblen Decklack besteht.

8. Folienleiterplatte nach einem der Ansprüche 1 bis 7,
**dadurch gekennzeichnet, daß** an einem freien Ende des als Anschlußleitung ausgebildeten Leiterplattenbereiches (5a-5d, 5i-5o) ein Steckerteil (13a-13d) befestigt ist.

9. Folienleiterplatte nach einem der Ansprüche 1 bis 8,
**dadurch gekennzeichnet, daß** die Schwächungslinie(n) (6a-6d, 7-12), über die jeweils der als Anschlußleitung ausgebildete Leiterplattenbereich (5a-5d, 5i-5o) mit einem oder mehreren anderen Leiterplattenbereichen (5e-5h, 17, 18) verbunden ist und/oder über die mindestens zwei flexible gedruckte Schaltungen (A-F) miteinander verbunden sind, eine Perforationslinie ist.

10. Folienleiterplatte nach einem der Ansprüche 1 bis 8,
**dadurch gekennzeichnet, daß** die Schwächungslinie (6a-6d, 7-12), über die jeweils der als Anschlußleitung ausgebildete Leiterplattenbereich (5a-5d, 5i-5o) mit einem oder mehreren anderen Leiterplattenbereichen (5e-5h) verbunden ist und/oder über die mindestens zwei flexible gedruckte Schaltungen (A-F) miteinander verbunden sind, eine geritzte Linie ist.

11. Folienleiterplatte nach Anspruch 9,
**dadurch gekennzeichnet, daß** innerhalb einer als Perforationslinie ausgebildeten Schwächungslinie (7-12), über die mindestens zwei Schaltkreise bzw. flexible gedruckte Schaltungen (A-F) miteinander verbunden sind, alternierend kurze stegartige Verbindungsabschnitte und um ein Mehrfaches längere Schlitzabschnitte angeordnet sind.

12. Folienleiterplatte nach einem der Ansprüche 1 bis 11,
**dadurch** gekennzeichhnet, daß ein Leiterplattenbereich (5e-5h, 17, 18), mit dem jeweils der als Anschlußleitung ausgebildete Leiterplattenbereich (5a-5d, 5i-5o) über die Schwächungslinie (6a-6d, 7-12) verbunden ist, ein Zwischensteg (17) oder ein Randsteg (18) ist.

13. Verfahren zur Herstellung einer Folienleiterplatte (15), mit mindestens einer Trägerfolie (1), auf der elektrische Leiterzüge (2) angeordnet sind, welche durch mindestens eine mit der Trägerfolie (1) und den Leiterzügen (2) verbundene Deckschicht (3) abgedeckt sind, wodurch mindestens eine flexible gedruckte Schaltung (A-F) aufgebaut ist, in der mindestens ein Leiterplattenbereich (5a-5d, 5i-5o) als Anschlußleitung ausgebildet ist, umfassend die Verfahrenschritte: Laminieren einer elektrischen Leiterschicht auf die Trägerfolie (1), Erzeugung eines Leiterbildes und Aufbringen der Deckschicht (3) auf den Verbund aus Trägerfolie (1) und Leiterzügen (2), wobei nach dem Aufbringen der Deckschicht (3) in dem Verbund von Trägerfolie (1) und Deckschicht (3) zwischen den als Anschlußleitung ausgebildeten Leiterplattenbereich (5a-5d, 5i-5o) und einen oder mehrere andere Leiterplattenbereiche (5e-5h) mindestens eine Schwächungslinie (6a-6d) eingebracht wird, und gegebenenfalls der mindestens eine als Anschlußleitung ausgebildeten Leiterplattenbereich (5a-5d, 5i-5o) mit einem Steckerteil (13a-13d) konfektioniert wird,
**dadurch gekennzeichnet, daß** die Trägerfolie (1) einschließlich der Leiterschicht als Rollenbahn (14) eingesetzt wird, die jeweils vor dem Drucken des Leiterbildes, vor der Entwicklung der Leiterzüge (2), vor dem Aufbringen der Deckschicht (3) und gegebenenfalls dem Konfektionieren aufgerollt und jeweils nach dem Drucken des Leiterbildes, nach der Entwicklung der Leiterzüge (2) und nach dem Einbringen der Schwächungslinien (6a, 6b, 6c, 6d, 7, 8, 9, 10, 11, 12) eingerollt sowie danach und gegebenenfalls nach dem Konfektionieren in Bögen (Nutzen) getrennt wird.

14. Verfahren nach Anspruch 13,
**dadurch gekennzeichnet, daß** durch die Erzeugung des Leiterbildes, insbesondere durch ein Drucken des Leiterbildes und eine Entwicklung der Leiterzüge (2) durch Ätzen, zwei oder mehr flexible gedruckte Schaltungen (A-F) gebildet werden und nach dem Aufbringen der Deckschicht (3) in den Verbund von Trägerfolie (1) und Deckschicht (3) zwischen diese Schaltungen (A-F) mindestens eine Schwächungslinie (7-12) eingebracht wird.

15. Verfahren nach Anspruch 13 oder 14,
**dadurch gekennzeichnet, daß** der Verbund von Trägerfolie (1) und Deckschicht (3) zur Herstellung der Schwächungslinie(n) (6a-6d, 7-12) perforiert wird.

16. Verfahren nach Anspruch 13 oder 14,
**dadurch gekennzeichnet, daß** der Verbund von Trägerfolie (1) und Deckschicht (3) zur Herstellung der Schwächungslinie(n) (6a-6d, 7-12) geritzt wird.

17. Verfahren nach einem der Ansprüche 13 bis 16,
**dadurch gekennzeichnet, daß** der als Anschlußleitung ausgebildete Leiterplattenbereich (5a-5d, 5i-5o) nach dem Aufbringen der Deckschicht (3) in einem Endabschnitt, der etwa der Größe eines Steckerteiles (13a-13d) entspricht, aus der Folienleiterplatte herausgetrennt und mit einem Steckerteil (13a-13d) konfektioniert wird.

18. Verfahren nach einem der Ansprüche 13 bis 16,
**dadurch gekennzeichnet, daß** in einem Endabschnitt des als Anschlußleitung ausgebildeten Leiterplattenbereiches (5a-5d, 5i-5o) nach dem Aufbringen der Deckschicht (3) aus der Schaltung selbst, insbesondere durch Faltung, ein Steckerteil gebildet wird.

19. Verfahren nach Anspruch 18,
**dadurch gekennzeichnet, daß** die Rollenbahn (14) vor der Bildung des Steckerteiles aufgerollt und danach in Bögen (Nutzen) geschnitten wird.

20. Verfahren nach einem der Ansprüche 17 bis 19,
**dadurch gekennzeichnet, daß** nach der Konfektionierung oder der Steckerbildung eine Qualitätsprüfung erfolgt.

21. Verfahren zur Montage einer Folienleiterplatte (15), mit mindestens einer Trägerfolie (1), auf der elektrische Leiterzüge (2) angeordnet sind, welche durch mindestens eine mit der Trägerfolie (1) und den Leiterzügen (2) verbundene Deckschicht (3) abgedeckt sind, wodurch mindestens eine flexible gedruckte Schaltung (A-F) aufgebaut ist, in der mindestens ein Leiterplattenbereich (5a-5d, 5i-5o) als Anschlußleitung ausgebildet ist, umfassend die Verfahrenschritte: Befestigen der Folienleiterplatte (15) an einem Bauteil (16) und kontaktierung der Anschlußleitung an mindestens einer elektrischen Anschlußstelle, wobei jeweils der als Anschlußleitung ausgebildete Leiterplattenbereich (5a-5d, 5i-5o) bis nach dem Befestigen der Folienleiterplatte (15) an dem Bauteil (16) über mindestens eine in dem Verbund von Trägerfolie (1) und Deckschicht (3) angeordnete Schwächungslinie (6a-6d) mit einem oder mehreren anderen Leiterplattenbereichen (5e-5h, 17, 18) verbunden bleibt, und anschließend an der Schwächungslinie (6d-6e) von der Folienleiterplatte (15) ab- oder daraus herausgetrennt, zu der jeweiligen elektrischen Anschlußstelle geführt und dort kontaktiert wird,
**dadurch gekennzeichnet, daß** vor dem Befestigen der Folienleiterplatte (15) an dem Bauteil (16) zwei oder mehr flexible gedruckte Schaltungen (A-F), die über mindestens eine in dem Verbund von Trägerfolie (1) und Deckschicht (3) angeordnete Schwächungslinie (7-12) untereinander in einem Bogen (Nutzen) in einer Rollenbahn (14) verbunden sind, an der Schwächungslinie (7-12) voneinander gelöst werden.

22. Verfahren nach Anspruch 21,
**dadurch gekennzeichnet, daß** die Folienleiterplatte (15) mit dem Bauteil (16) zum Befestigen verklebt, ultraschallverschweißt oder mittels eines Klettbandes verbunden wird.

23. Verfahren nach Anspruch 22,
**dadurch gekennzeichnet, daß** zum Verkleben ein doppelseitiges Hybridklebeband eingesetzt wird.

## Claims

1. A foil printed circuit board (15), comprising at least one carrier foil (1) on which are arranged electrical conductor tracks (2) which are covered by at least one cover layer (3) bonded to the carrier foil (1) and the conductor tracks (2), whereby at least one flexible printed circuit (A-F) is constructed in which at least one printed circuit board region (5a-5d, 5i-5o) is designed as an attachment lead, wherein the printed circuit board region (5a-5d, 5i-5o) designed as an attachment lead is connected to one or several other printed circuit board regions (5e-5h, 17, 18) via at least one weakness line (6a-6d) arranged in the bonding of the carrier foil (1) and the cover layer (3),
**characterised in that** the carrier foil (1), including the conductor tracks (2) and the cover layer (3), is in the form of a reeled web (14) in which several flexible printed circuits (A-F) are arranged, the said printed circuits being arranged in sheets (panels), connected via at least one weakness line (7-12) and manually separable from one another.

2. A foil printed circuit board according to Claim 1,
**characterised in that** several printed circuit board regions (5a-5d, 5i-5o) are designed as attachment leads.

3. A foil printed circuit board according to Claim 1 or 2,
**characterised in that** a printed circuit board region, to which the printed circuit board region (5a-5d, 5i-5o) designed as an attachment lead is in each case connected via the weakness line (6a-6d), is a further printed circuit board region (5a-5d, 5i-5o) designed as an attachment lead.

4. A foil printed circuit board according to one of Claims 1 to 3,
**characterised in that** a printed circuit board region (5e-5h), to which the printed circuit board region (5a-5d, 5i-5o) designed as an attachment lead is in each case connected via the weakness line (6a-6d), is a printed circuit board region intended for the attachment to a structural component, like a motor vehicle body component.

5. A foil printed circuit board according to one of Claims 1 to 4,
**characterised in that** the carrier foil (1), the conductor tracks (2) and the cover layer (3) are connected via bonded connections (4, 4a, 4b).

6. A foil printed circuit board according to one of Claims 1 to 5,
**characterised in that** the cover layer (3) consists of a cover foil.

7. A foil printed circuit board according to one of Claims 1 to 5,
**characterised in that** the cover layer (3) consists of a flexible cover lacquer.

8. A foil printed circuit board according to one of Claims 1 to 7, **characterised in that** a connector component (13a-13d) is attached to a free end of the printed circuit board region (5a-5d, 5i-5o) designed as an attachment lead.

9. A foil printed circuit board according to one of Claims 1 to 8,
**characterised in that** the weakness line(s) (6a-6d, 7-12), via which the printed circuit board region (5a-5d, 5i-5o) designed as an attachment lead is in each case connected to one or several other printed circuit board regions (5e-5h, 17, 18) and/or via which at least two flexible printed circuits (A-F) are connected to one another, is a perforation line.

10. A foil printed circuit board according to one of claims 1 to 8,
**characterised in that** the weakness line (6a-6d, 7-12), via which the printed circuit board region (5a-5d, 5i-5o) designed as an attachment lead is in each case connected to one or several other printed circuit board regions (5e-5h) and/or via which at least two flexible printed circuits (A-F) are connected to one another, is a scored line.

11. A foil printed circuit board according to Claim 9,
**characterised in that** short web-like connecting portions and slotted portions which are multiply longer are alternately arranged within a weakness line (7-12) designed as a perforation line via which at least two circuits or flexible printed circuits (A-F) are connected to one another.

12. A foil printed circuit board according to one of Claims 1 to 11,
**characterised in that** a printed circuit board region (5e-5h, 17, 18), to which the printed circuit board region (5a-5d, 5i-5o) designed as an attachment lead is in each case connected via the weakness line (6a-6d, 7-12), is an interstitial web (17) or a marginal web (18).

13. A method for manufacturing a foil printed circuit board (15), comprising at least one carrier foil (1) on which are arranged electrical conductor tracks (2) which are covered by at least one cover layer (3) bonded to the carrier foil (1) and the conductor tracks (2), whereby at least one flexible printed circuit (A-F) is constructed in which at least one printed circuit board region (5a-5d, 5i-5o) is designed as an attachment lead, comprising the method steps:
laminating an electrical conductor layer on to the carrier foil (1), creating a conductive pattern and applying the cover layer (3) on the bonding of the carrier foil (1) and the conductor tracks (2), wherein, after the application of the cover layer (3), at least one weakness line (6a-6d) is inserted in the bonding of the carrier foil (1) and the cover layer (3) between the printed circuit board region (5a-5d, 5i-5o) designed as an attachment lead and one or several other printed circuit board regions (5e-5h), and optionally the at least one printed circuit board region (5a-5d, 5i-5o) designed as an attachment lead is assembled with a connector component (13a-13d),
**characterised in that** the carrier foil (1), including the conductor layer, is employed as a reeled web (14) which in each case is unrolled before printing the conductive pattern, before developing the conductor tracks (2), before applying the cover layer (3) and optionally before assembly, and in each case is rolled up after printing the conductive pattern, after developing the conductor tracks (2) and after inserting the weakness lines (6a, 6b, 6c, 6d, 7, 8, 9, 10, 11, 12), and thereafter, and optionally after assembly, is separated into sheets (panels).

14. A method according to Claim 13,
**characterised in that** two or more flexible printed circuits (A-F) are formed by creating the conductive pattern, particularly by printing the conductive pattern and developing the conductor tracks (2) by etching, and after the application of the cover layer (3) at least one weakness line (7-12) is inserted between these circuits (A-F) into the bonding of the carrier foil (1) and the cover layer (3).

15. A method according to Claim 13 or 14,
**characterised in that** the bonding of the carrier foil (1) and the cover layer (3) is perforated to create the weakness line(s) (6a-6d, 7-12).

16. A method according to Claim 13 or 14,
**characterised in that** the bonding of the carrier foil (1) and the cover layer (3) is scored to create the weakness line(s) (6a-6d, 7-12).

17. A method according to one of Claims 13 to 16,
**characterised in that** the printed circuit board region (5a-5d, 5i-5o) designed as an attachment lead, after the application of the cover layer (3), is separated out from the foil printed circuit board in an end portion which corresponds approximately to the size of a connector component (13-13d), and is assembled with a connector component (13a-13d).

18. A method according to one of Claims 13 to 16,
**characterised in that** a connector component is formed, after the application of the cover layer (3), in an end portion of the printed circuit board region (5a-5d, 5i-5o) designed as an attachment lead from the circuit itself, particularly by folding.

19. A method according to Claim 18,
**characterised in that** the reeled web (14) is unrolled before the formation of the connector component and thereafter is cut into sheets (panels).

20. A method according to one of Claims 17 to 19,
**characterised in that** a quality inspection takes place after the assembly or the formation of the connector.

21. A method for mounting a foil printed circuit board (15), comprising at least one carrier foil (1) on which are arranged electrical conductor tracks (2) which are covered by at least one cover layer (3) bonded to the carrier foil (1) and the conductor tracks (2), whereby at least one flexible printed circuit (A-F) is constructed in which at least one printed circuit board region (5a-5d, 5i-5o) is designed as an attachment lead, comprising the method steps:
attaching the foil printed circuit board (15) to a structural component (16) and
contacting the attachment lead at at least one electrical connection point,
wherein the printed circuit board region (5a-5d, 5i-5o) designed as an attachment lead in each case remains connected to one or several other printed circuit board regions (5e-5h, 17, 18) via at least one weakness line (6a-6d) arranged in the bonding of the carrier foil (1) and the cover layer (3) until after the attaching of the foil printed circuit board (15) to the structural component (16), and is then separated from the foil printed circuit board (15), or separated out therefrom, at the weakness line (6d-6e), is guided to the respective electrical connection point and contacted there,
**characterised in that**, before attaching the foil printed circuit board (15) to the structural component (16), two or more flexible printed circuits (A-F), which are interconnected in a sheet (panel) in a reeled web (14) via at least one weakness line (7-12) arranged in the bonding of the carrier foil (1) and the cover layer (3), are detached from one another at the weakness line ((7-12).

22. A method according to Claim 21,
**characterised in that** the foil printed circuit board (15) is bonded, ultrasonically welded or connected by means of a hook and loop strip, to the structural component (16) for attachment thereto.

23. A method according to Claim 22,
**characterised in that** a double-sided hybrid adhesive tape is used for bonding.

## Revendications

1. Panneau à circuit imprimé en feuille mince (15), comprenant au moins un film support (1), sur lequel sont disposés des circuits conducteurs (2) électriques, qui sont recouverts par au moins une couche de revêtement (3) reliée au film support (1) et aux circuits conducteurs (2), moyennant quoi au moins un circuit imprimé flexible (A-F) est mis en place, dans lequel au moins une zone de panneau à circuit imprimé (5a-5d, 5i-5o) est conçue comme ligne de raccordement, la zone de panneau à circuit imprimé (5a-5d, 5i-5o) conçue comme ligne de raccordement étant reliée au moyen d'au moins une ligne d'affaiblissement (6a-6d) disposée dans la jonction du film support (1) et de la couche de revêtement (3) à une ou plusieurs autres zones de panneau à circuit imprimé (5e-5h, 17, 18),
**caractérisé en ce que** le film support (1), y compris les circuits conducteurs (2) et la couche de revêtement (3), est réalisée sous la forme de bande à rouleaux (14), dans laquelle sont disposés plusieurs circuits (A-F) imprimés flexibles, pouvant être séparés manuellement les uns des autres, reliés au moyen d'au moins une ligne d'affaiblissement (7-12) et disposés en feuilles (flan).

2. Panneau à circuit imprimé en feuille mince selon la revendication 1,
**caractérisé en ce que** plusieurs zones de panneau à circuit imprimé (5a-5d, 5i-5o) sont conçues comme des lignes de raccordement.

3. Panneau à circuit imprimé en feuille mince selon la revendication 1 ou 2,
**caractérisé en ce qu'**une zone de panneau à circuit imprimé, avec laquelle respectivement la zone de panneau à circuit imprimé (5a-5d, 5i-5o) conçue comme ligne de raccordement est reliée au moyen de la ligne d'affaiblissement (6a-6d), est une autre zone de panneau à circuit imprimé (5a-5d, 5i-5o) conçue comme ligne de raccordement.

4. Panneau à circuit imprimé en feuille mince selon l'une quelconque des revendications 1 à 3,
**caractérisé en ce qu'**une zone de panneau à circuit imprimé (5e-5h), avec laquelle respectivement la zone de panneau à circuit imprimé (5a-5d, 5i-5o) conçue comme ligne de raccordement est reliée au moyen de la ligne d'affaiblissement (6a-6d), est une zone de panneau à circuit imprimé destinée à la fixation sur un composant comme une partie de carrosserie de véhicule automobile.

5. Panneau à circuit imprimé en feuille mince selon l'une quelconques des revendications 1 à 4,
**caractérisé en ce que** le film support (1), les circuits conducteurs (2) et la couche de revêtement (3) sont reliés au moyen d'assemblages collés (4, 4a, 4b).

6. Panneau à circuit imprimé en feuille mince selon l'une quelconque des revendications 1 à 5,
**caractérisé en ce que** la couche de revêtement (3) est à base d'un film de revêtement.

7. Panneau à circuit imprimé en feuille mince selon l'une quelconque des revendications 1 à 5,
**caractérisé en ce que** la couche de revêtement (3) est à base d'une laque de revêtement flexible.

8. Panneau à circuit imprimé en feuille mince selon l'une quelconque des revendications 1 à 7,
**caractérisé en ce qu'**une partie de fiche (13a-13d) est fixée sur une extrémité libre de la zone de panneau à circuit imprimé(5a-5d, 5i-5o) conçue comme ligne de raccordement.

9. Panneau à circuit imprimé en feuille mince selon l'une quelconque des revendications 1 à 8,
**caractérisé en ce que** la (les) ligne(s) d'affaiblissement (6a-6d, 7-12), par laquelle (lesquelles) respectivement la zone de panneau à circuit imprimé(5a-5d, 5i-5o) conçue comme ligne de raccordement est reliée à une ou plusieurs autres zones de panneau à circuit imprimé (5e-5h, 17, 18) et/ou par laquelle (lesquelles) au moins deux circuits imprimés flexibles (A-F) sont reliés entre eux, est une ligne de perforation.

10. Panneau à circuit imprimé en feuille mince selon l'une quelconque des revendications 1 à 8,
**caractérisé en ce que** la ligne d'affaiblissement (6a-6d, 7-12), par laquelle respectivement la zone de panneau à circuit imprimé (5a-5d, 5i-5o) conçue comme une ligne de raccordement est reliée à une ou plusieurs autres zones de panneau à circuit imprimé (5e-5h) et/ou par laquelle au moins deux circuits imprimés flexibles (A-F) sont reliés entre eux, est une ligne gravée.

11. Panneau à circuit imprimé en feuille mince selon la revendication 9,
**caractérisé en ce qu'**à l'intérieur d'une ligne d'affaiblissement (7-12) conçue comme ligne de perforation, par laquelle au moins deux circuits ou circuits imprimés flexibles (A-F) sont reliés entre eux, sont disposées en alternance de courtes sections de liaison du type barrette et des parties de fente plusieurs fois plus longues.

12. Panneau à circuit imprimé en feuille mince selon l'une quelconque des revendications 1 à 11,
**caractérisé en ce qu'**une zone de panneau à circuit imprimé (5e-5h, 17, 18), avec laquelle respectivement la zone de panneau à circuit imprimé (5a-5d, 5i-5o) conçue comme ligne de raccordement est reliée au moyen de la ligne d'affaiblissement (6a-6d, 7-12), est une barrette intermédiaire (17) ou une barrette périphérique (18).

13. Procédé pour la fabrication d'une panneau à circuit imprimé en feuille mince (15), comprenant au moins un film support (1), sur lequel sont disposés des circuits conducteurs (2) électriques, lesquels sont recouverts par au moins une couche de revêtement (3) reliée au film support (1) et aux circuits conducteurs (2), de sorte qu'au moins un circuit imprimé flexible (A-F) est mis en place, dans lequel au moins une zone de panneau à circuit imprimé (5a-5d, 5i-5o) est conçue comme une ligne de raccordement, comprenant les étapes de procédé suivantes : laminage d'une couche conductrice électrique sur le film support (1), génération d'un dessin de conducteurs et application de la couche de revêtement (3) sur l'assemblage constitué du film support (1) et des circuits conducteurs (2), au moins une ligne d'affaiblissement (6a-6d) étant introduite après l'application de la couche de revêtement (3) dans l'assemblage du film support (1) et de la couche de revêtement (3) entre la zone de panneau à circuit imprimé (5a-5d, 5i-5o) conçue comme ligne de raccordement et une ou plusieurs autres zones de panneau à circuit imprimé (5e-5h), et éventuellement la au moins une zone de panneau à circuit imprimé (5a-5d, 5i-5o) conçue comme ligne de raccordement étant confectionnée avec une partie de fiche (13a-13d),
**caractérisé en ce que** le film support (1), y compris la couche conductrice, est utilisée comme bande à rouleaux (14), qui est déroulée respectivement avant l'impression du dessin de conducteurs, avant le développement des circuits conducteurs (2), avant l'application de la couche de revêtement (3), et éventuellement la confection, et est enroulé respectivement après l'impression du dessin de conducteurs, après le développement des circuits conducteurs (2) et après l'introduction des lignes d'affaiblissement (6a, 6b, 6c, 6d, 7, 8, 9, 10, 11, 12) et est séparée ensuite et éventuellement après la confection en feuilles (flan).

14. Procédé selon la revendication 13,
**caractérisé en ce que**, par la génération du dessin de conducteurs, en particulier par une impression du dessin de conducteurs et un développement des circuits conducteurs (2) par décapage, deux circuits imprimés flexibles (A-F) ou davantage sont formés et au moins une ligne d'affaiblissement (7-12) est introduite après l'application de la couche de revêtement (3) dans l'assemblage du film support (1) et de la couche de revêtement (3) entre ces circuits (A-F).

15. Procédé selon la revendication 13 ou 14,
**caractérisé en ce que** l'assemblage du film support (1) et de la couche de revêtement (3) est perforé pour la fabrication de la (des) ligne(s) d'affaiblissement (6a-6d, 7-12).

16. Procédé selon la revendication 13 ou 14,
**caractérisé en ce que** l'assemblage du film support (1) et de la couche de revêtement (3) est gravé pour la fabrication de la (des) ligne(s) d'affaiblissement (6a-6d, 7-12).

17. Procédé selon l'une quelconque des revendications 13 à 16,
**caractérisé en ce que** la zone de panneau à circuit imprimé (5a-5d, 5i-5o) conçue comme ligne de raccordement est séparée, après l'application de la couche de revêtement (3) dans une section d'extrémité, qui correspond à peu près à la grandeur d'une partie de fiche (13a-13d), du panneau à circuit imprimé en feuille mince et est confectionnée avec une partie de fiche (13a-13d).

18. Procédé selon l'une quelconque des revendications 13 à 16,
**caractérisé en ce que** une partie de fiche est formée dans une section d'extrémité de la zone de panneau à circuit imprimé (5a-5d, 5i-5o) conçue comme ligne de raccordement après l'application de la couche de revêtement (3) à partir du circuit même, en particulier par pliage.

19. Procédé selon la revendication 18,
**caractérisé en ce que** la bande à rouleaux (14) est déroulée avant la formation de la partie de fiche et est coupée ensuite en feuilles (flan).

20. Procédé selon l'une quelconque des revendications 17 à 19,
**caractérisé en ce qu'**un essai de qualité est effectué après la confection ou après la formation de fiche.

21. Procédé pour le montage d'un panneau à circuit imprimé en feuille mince (15), comprenant au moins un film support (1), sur lequel sont disposés des circuits conducteurs (2) électriques, lesquels sont recouverts par au moins une couche de revêtement (3) reliée au film support (1) et aux circuits conducteurs (2), au moins un circuit imprimé flexible (A-F) étant mis en place, dans lequel au moins une zone de panneau à circuit imprimé (5a-5d, 5i-5o) est conçue comme ligne de raccordement, comprenant les étapes de procédé suivantes : fixation du panneau à circuit imprimé en feuille mince (15) sur un composant (16) et contact de la ligne de raccordement sur au moins un point de raccordement électrique, respectivement la zone de panneau à circuit imprimé (5a-5d, 5i-5o) conçue comme ligne raccordement restant reliée jusqu'après la fixation du panneau à circuit imprimé en feuille mince (15) sur le composant (16) au moyen d'au moins une ligne d'affaiblissement (6a-6d) disposée dans l'assemblage du film support (1) et de la couche de revêtement (3) à une ou plusieurs autres zones de panneau à circuit imprimé (5e-5h, 17, 18), et étant ensuite détachée sur la ligne d'affaiblissement (6d-6e) du panneau à circuit imprimé en feuille mince (15) ou séparée de celle-ci, guidée vers le point de branchement électrique respectif et étant amenée en contact à cet endroit,
**caractérisé en ce que**, avant la fixation du panneau à circuit imprimé en feuille mince (15) sur le composant (16), deux circuits imprimés flexibles ou plus (A-F), qui sont reliés au moyen d'au moins une ligne d'affaiblissement (7-12) disposée dans l'assemblage du film support (1) et de la couche de revêtement (3) entre eux dans une feuille (flan) dans une bande à rouleaux (14), sont détachés l'un de l'autre sur la ligne d'affaiblissement (7-12).

22. Procédé selon la revendication 21,
**caractérisé en ce que** le panneau à circuit imprimé en feuille mince (15) est collé avec le composant (16) pour la fixation, soudé par ultrasons ou relié au moyen d'une bande velcro.

23. Procédé selon la revendication 22,
**caractérisé en ce qu'**on utilise, pour le collage, une bande adhésive hybride à double face.
